# EUROPEAN PATENT APPLICATION

(11) **EP 1 603 372 A1**
(43) Date of publication of application: **07.12.2005**
(21) Application number: 05104768.6
(22) Date of filing: 02.06.2005
(51) Int. Cl.: H05K 1/02, H05K 9/00

(54) **Printed circuit board with shielded path and method of manufacturing printed circuit board with shielded path**

(30) Priority: 02.06.2004 PL 36833704
(71) Applicant: Advanced Digital Broadcast Polska Sp. zo.o., 65-119 Zielona Gora (PL); Advanced Digital Broadcast Ltd., Hsin-Tien City, Taipei Count, 231 Taiwan, R.O.C. (TW)
(72) Inventor: Wabiszczewicz, Zbigniew Advanced Digital Broadcast, 65-559, Zielona Gora, Poland (PL)
(74) Representative: Hudy, Ludwik

(57) **Abstract**

A printed circuit board with at least one shielded path placed on an outer layer of the board is provided with a shield composed of SMD elements (215) and shielding paths and/or planes, placed on both sides along the shielded path. The shielding paths or planes (213, 214) are connected to the ground, and the SMD elements (215) create a line of SMD elements, which are placed over the shielded path (212), and whose contacts (216, 217), extending beyond the shielded path (212), are connected to the shielding paths or planes (213, 214), placed on both sides of the shielded path (212).

## Description

The present invention relates to a printed circuit board with a shielded path and a method of manufacturing a printed circuit board with a shielded path.

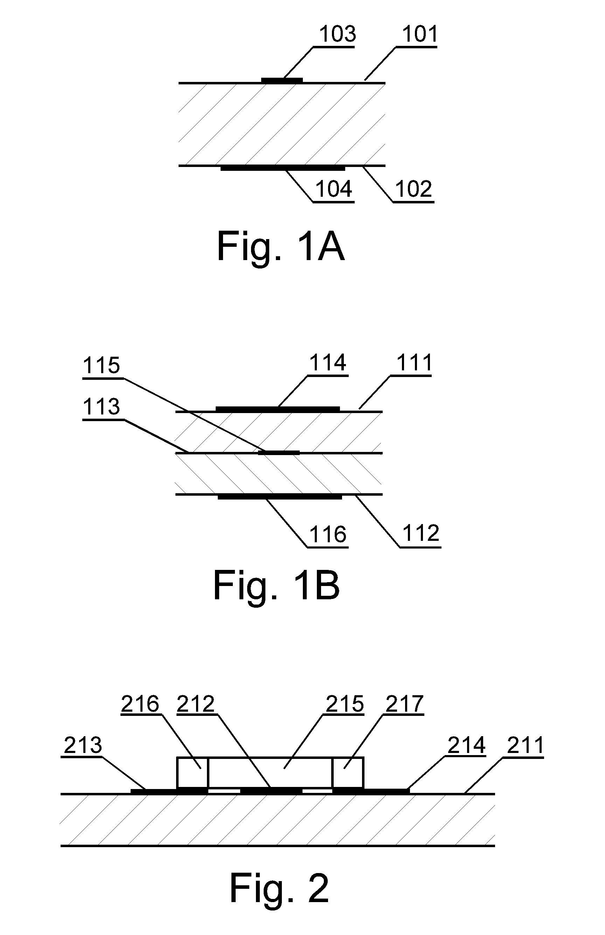

Various improvements have been made in shielding the paths of printed circuit boards and adjusting the impedance of their paths. This can be achieved by providing additional paths or planes placed in proximity of the path to be shielded. The two most common examples are a "microstrip" shown in Fig. 1 A and a "stripline" shown in Fig. 1 B. In the "microstrip" example, a signal path 103 on a layer 101 is shielded by a path 104 placed on a layer 102 and connected to the ground. However, this does not provide protection against interference from all sides. A better protection is provided by the "stripline", where a signal path 115 on an inner layer 113 is shielded by paths 114 and 116, placed on layers 111 and 112, respectively. This requires at least a three-layer board.

The European patent application no. EP0800338 entitled *"Devices for minimizing electromagnetic radiation in printed circuit boards and other electronic circuit carriers"* presents a method for shielding of elements on the PCB by covering them with an insulating element. However, the insulating element is specific and must be suited to the shielded element. The manufacture of such a specific element, as well as its assembly on the PCB, complicates the production process and increases its cost.

An article *"Circuit board guarding techniques"* published in June 1990 in *Research Disclosure Journal,* number 31482, presents a method for shielding a path on an inner layer of a printed circuit board by means of paths placed on each of its sides and on the upper and lower layers, which are connected to the ground. This method thus requires paths on the inner layer of the board, and the shield is created only by these paths.

There is no known shielding solution that would allow effective shielding of paths on the outer layers, i.e. the upper and lower layers of printed circuit boards in a way that does not complicate the normal process and does not increase production costs.

The aim of the present invention is to create effective shielding of paths on outer layers to avoid or at least greatly diminish the drawbacks of prior art.

The idea of the invention is that in a printed circuit board with a shielded path placed on its outer layer, the shield consists of an arrangement of elements, comprising paths or planes placed along the shielded path on both sides, which are connected to the shielding arrangement, placed on the lower layer and enclosing the shielded path and connected to the ground, and a line of SMD elements placed over the shielded path, whose contacts extending outside the shielded path are connected to paths placed at both sides of the shielded path.

The shielded path can be additionally covered with a solder mask layer, and the line of SMD elements can be composed of at least two SMD elements connected in series, whose contacts are interconnected. The SMD elements are connected by means of solder paste placed on the solder mask layer.

Distances between the SMD elements in the line can be as small as possible using current state-of-the-art technology.

A second path to be shielded can be situated on the same layer in parallel to the shielded path, and thereby the arrangement of the elements constituting the shield can enclose both paths.

Preferably, the shielding arrangement placed on the lower layer is a conductive path or plane, and the shielding arrangement placed on the lower layer is placed on the opposite outer layer.

Preferably, symmetrically to the shielded path, there is placed on the opposite layer a second path to be shielded, and the shielding arrangement placed on the lower layer is a second line of SMD elements, placed over the second path to be shielded.

The board can have three layers. There can be a path or a plane placed on its inner layer between the shielded paths, which may be in contact with the upper and lower line of SMD elements.

Preferably, the SMD elements are resistors with resistance close to zero.

The idea of the invention is also that, in the method for manufacturing a printed circuit board with a shielded path placed on its outer layer, the shield is composed of an arrangement of elements, including paths or planes placed along the shielded path at its both sides, which are connected by means of vias with the shielding arrangement, which is placed on the lower layer and encloses the shielded path and is connected to the ground, and a line of SMD elements, placed over the shielded path, whose contacts, extending outside the shielded path, are connected with the planes or paths placed along the shielded path.

In the accompanying drawings one of the possible embodiments of the present invention is shown, where:
Fig. 1 A presents a *"microstrip"* arrangement;
Fig. 1 B presents a *"stripline"* arrangement;
Fig. 2 presents a cross section of a single-layer printed circuit board with a shielded path;
Fig. 3 presents a top plan view of a PCB with SMD elements placed close to each other;
Fig. 4 presents a top plan view of a PCB with SMD elements placed at a certain distance to each other;
Fig. 5 presents a cross section of a double-layer PCB with a shielded path at its top outer layer;
Fig. 6 presents a cross section of a double-layer PCB with shielded paths on both of its outer layers;
Fig. 7 presents a cross section of a multi-layer PCB with a shielded path at its top outer layer;
Fig. 8 presents a top plan view of a PCB with a shielded path with a width greater than a length of a single SMD element; and
Fig. 9 presents a detailed view of the cross section of the PCB shown in Fig. 8.

Fig. 2 presents a cross section of a single-layer PCB with a shielded path. Over the path 212, placed on the layer 211, there is placed an SMD element 215, which ends with in contact surfaces, called contacts 216 and 217. The contacts 216 and 217 are connected to paths 213 and 214 respectively, which are connected to the ground and are placed along the shielded path 212 at both of its sides. In this embodiment, the path 212 is shielded only from one side. Such shielding is preferable especially when the bottom layer of the board is metallized. This feature makes it possible to obtain specific path impedance.

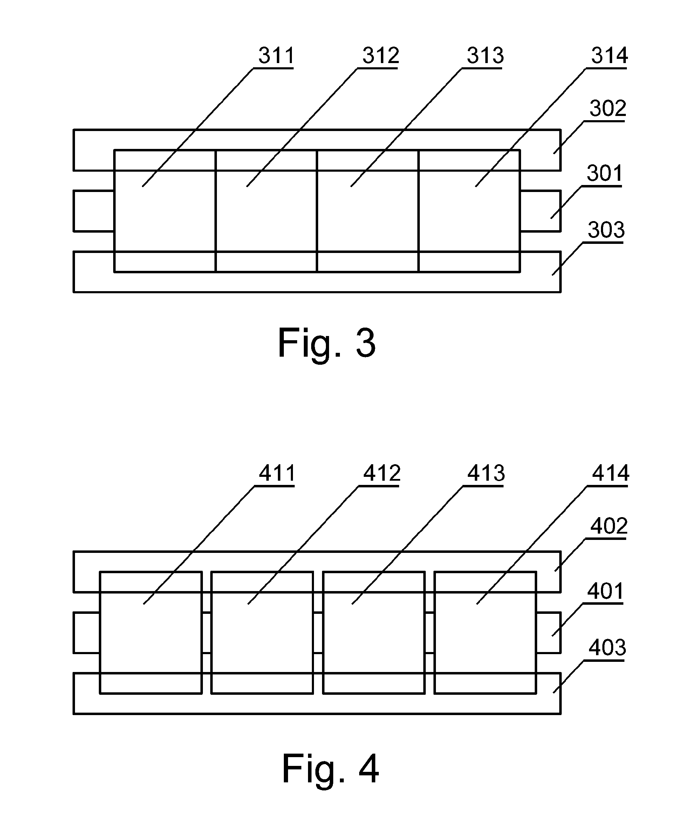

Fig. 3 presents a top view of a PCB with a shielded path 301. On both sides of the path 301 there are placed paths and/or planes 302 and 303 connected to the ground. Over the path there is placed a line of resistors 311, 312, 313 and 314, whose contacts are connected to the paths and/or the planes 302 and 303. The contacts of the resistors 311, 312, 313 and 314 extend beyond the shielded path 301. The chain of SMD elements 311, 312, 313, 314, for example the resistors, constitutes the top part of the tunnel, which encompasses the shielded path 301. The SMD elements 311, 312, 313, 314 are placed adjacent to each other, additionally acting as an insulation and guard for the path 301 from external influences, such as dust, and in this way preventing possible short-circuits and positively improving the durability of the design.

Fig. 4 presents an arrangement in which there are spaces between the elements 411, 412, 413, 414 which result from the production process. Such shielding is less efficient, but it still ensures a certain level of path shielding. In order to provide a fully effective shield, the distances between the SMD elements should be as small as possible (for example - the smallest distances allowed by the production process). Spacings between the SMD elements 411, 412, 413, 414 can be deliberately introduced to ensure better cooling of the path 401. This provides both shielding for the path 401 and a free flow of air. In this example, the air flows, for instance, through the clearance between the elements 411 and 412, inside the tunnel composed of the elements 412, 402, 403, 401 and the board surface, on which paths 401, 402 and 403 are placed, and next through the clearance between the elements 412 and 413.

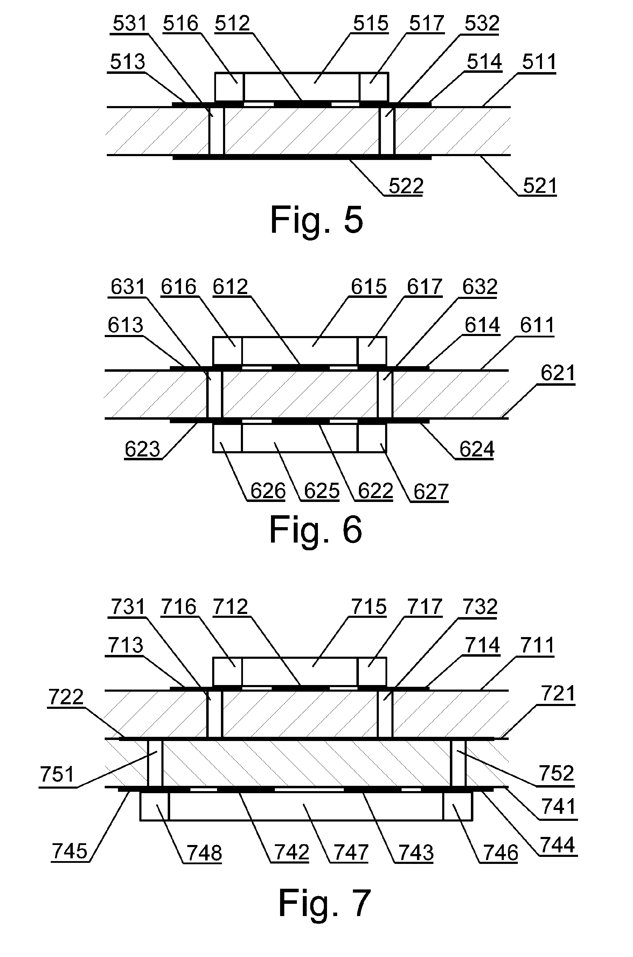

Fig. 5 presents a path 512 to be shielded, which is placed on the top layer 511 of a double-layer PCB. There is an SMD element 515 placed on the path, which ends with contact surfaces 516 and 517. The contacts 516 and 517 are connected to shielding planes or paths 513 and 514, which are placed along the shielded path 512 on both sides. At the bottom surface 521 of the board, there is placed a path 522, connected to the ground, which extends along the path 512, and which constitutes the shielding arrangement. The path 522 is connected to the paths 513 and 514 by means of metallised holes, so-called vias, 531 and 532. Therefore, the path 522, the vias 531 and 532, the paths 513 and 514, and the SMD element 515 surround the path 512 on all sides, so that they constitute a shield which effectively protects the path 512 against any interference, as well as other elements against internal interference generated by the path. The SMD element might be a resistor with a resistance close to zero. For example, it can be a 1210-type SMD resistor, having the length of 3.1 mm, the width of 2.6 mm, the height of 0.6 mm, and with the width of contact surfaces of 0.5 mm. However, it is possible to use other SMD elements, for example non-zero resistors, capacitors or inductors, in order to achieve appropriate shield parameters, which allows appropriate path impedance to be achieved

The SMD elements in the line may be identical or may be made up of a line of different elements. The advantage of using the SMD elements is that no additional procedures are necessary for the production of the board. On a typical printed circuit board there are many different SMD elements. Hence, the addition of further components does not pose a significant additional time-factor for production. Placing extra elements does not require the introduction of any special process which might be much more time-consuming and impose additional costs.

In the presented embodiment, the indicators 513, 514, 522 are related to the paths. However, the paths may be replaced by larger planes, which are connected to the ground. The vias 531, 532 need not necessarily be placed immediately underneath the contact surfaces of the resistors, but they can be located elsewhere, the only requirement being that they connect the paths 513 and 514 with the path 522. The path 522 is presented as an example. An alternative shielding arrangement may be placed on the lower surface instead, such as a resistor or another element, or a specific conductive plane.

Fig. 6 presents a cross section of a printed circuit board with paths 612 and 622 to be shielded, which are placed in parallel to each other at the outer layers 611 and 621, respectively. The shield around the paths is composed of a line of resistors 615 connected to the paths 613 and 614 by contacts 616 and 617 respectively, which are connected by vias 631 and 632 with paths 623 and 624, respectively, that connect the line of resistors 625 to contacts 626 and 627. Such shielding is effective when the paths 612 and 622 transmit a different signal. It allows for the reduction of production costs because elements shielding the paths from the lower layer are not necessary. Moreover, a decrease of production cost is obtained by miniaturizing the whole printed circuit board by placing its components on the bottom part of the printed circuit board.

Fig. 7 presents a cross section of a multilayer, here a three-layer printed circuit board, whose path to be shielded 712 is placed on the top outer layer 711, while a shielding path or plane 722 is placed on the inner layer 721. The shield consists of a resistor 715, whose contacts 716, 717 are connected to paths 713and 714 respectively, which, by means of vias 731, 732, are connected to the path 722. This allows the placement of other paths, 742 and 743, on the second outer layer 741. The paths 742, 743 can also be shielded by means of a resistor 747, whose contacts 746, 748 are connected to paths 744and 745 respectively, which, by means of vias 751, 752, are connected to the path 722. Such a solution is characterized by better shielding properties than the solution depicted in Fig. 6, although production costs are raised due to the need to create the additional layer 741 on the PCB.

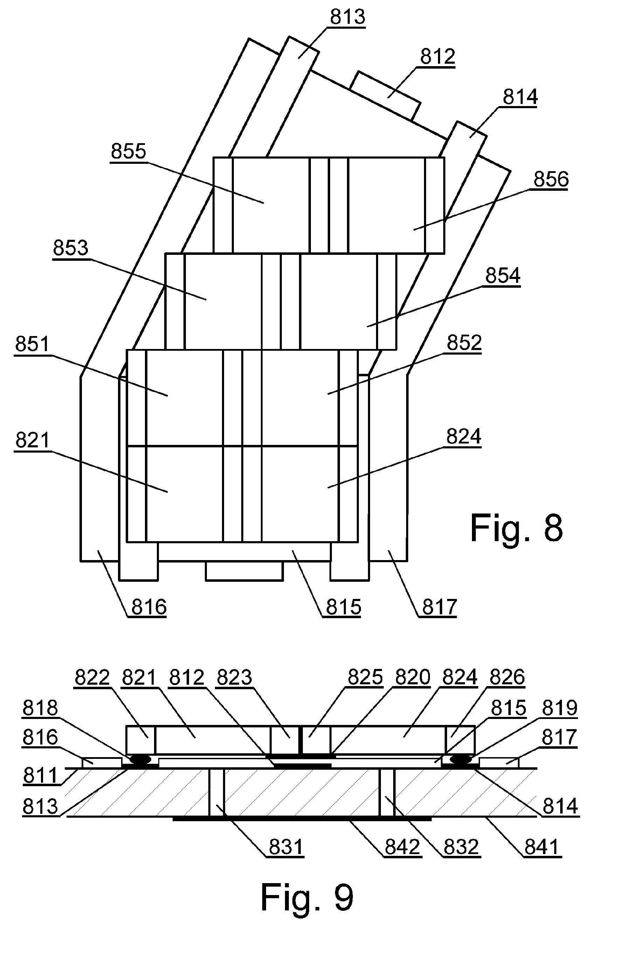

Fig. 8 shows a top-view of the PCB with a shielded path having a width greater than the length of a single SMD element, as well as having a variable angle of placement. The path 812 is covered with a solder mask layer made of epoxy resin. The outer layer of the shield is composed of lined up elements connected in series, marked with the numbers 821 and 824, 851 and 852, 853 and 854, 855 and 856, whose contacts, extending outside the solder mask layer 815, are soldered to paths 813 and 814, connected to the ground. The contacts 823, 825 of the SMD elements placed on the solder mask layer 815, are connected with each other by means of solder paste 820, put on the solder mask. Should a path 812 be required, more than two elements connected with each other in series can be emplaced. At the sides of paths 813, 814 there can also be a solder mask placed 816, 817. The solder mask can be placed on the path 812 also in the case when it is covered only with a line consisting of single SMD elements, which ensures that it has additional shielding and protection against mechanical damage.

Fig. 9 presents a cross section of the board presented in Fig. 8. There is a solder mask 815 placed on the path 812, situated on the top layer 811 of the PCB, which is also placed on the sides 816, 817 of the paths 813 and 814 respectively. These paths, 813 and 814, are connected by means of vias 831, 832 to the path 842, connected to the ground, placed on the bottom layer 841 of the PCB. The elements 821 and 824 adhere to each other by means of contacts 823, 824, which are connected together by means of solder paste 820, put on the solder mask 815. The outer contacts 822 and 826 are connected by means of solder paste 818, 819 with the paths 813 and 814, respectively. The placement of additional solder masks 815, 816, 817 further isolates the path 812 from external influences, leading to an increase of the durability and the resistance of the PCB.

The preferred embodiment having been thus described, it will now be evident to those skilled in the art that further variation thereto may be contemplated. Such variations are not regarded as a departure from the invention, the true scope of the invention being set forth in the claims appended hereto.

## Claims

1. A printed circuit board with a shielded path placed on an outer layer of the printed circuit board, where a shield of the shielded path is constituted by an arrangement of elements connected to the ground, **characterized in that** the arrangement of elements constituting the shield comprises shielding paths or planes (213, 214) placed at both sides along the shielded path and a line of SMD elements (215) with contacts, whereby the SMD elements (215) are placed over the shielded path (212), and their contacts (216, 217) extending beyond the shielded path (212) are connected with the shielding paths or planes (213, 214).

2. The board according to claim 1, **characterized in that** the shielded path (812) is covered with a solder mask layer (815).

3. The board according to claim 2, **characterized in that** the line of SMD elements is created by at least two SMD elements (821 and 824, 851 and 852, 853 and 854, 855 and 856) connected in series, whose contacts (823 825), which are adjacent, are connected by solder paste (820) placed on a solder mask layer (815).

4. The board according to claim 1, **characterized in that** distances between SMD elements (311, 312, 313, 314) and (411, 412, 413, 414) in the line are the smallest distances allowed by a production process.

5. The board according to claim 1, **characterized in that** in parallel to the shielded path (742), there is placed on the same layer a second path (743) to be shielded, and the arrangement of elements constituting the shield encloses both paths (742, 743).

6. The board according to claim 1, **characterized in that** the arrangement of elements constituting the shield is additionally connected, by vias (531, 532), with a shielding arrangement, which encloses the shielded path (512) and which is placed on the lower layer or the second outer layer (521).

7. The board according to claim 6, **characterized in that** the shielding arrangement placed on the lower layer or the second outer layer or surface is a conductive path or plane (522).

8. The board according to claim 6, **characterized in that** symmetrically to the shielded path (612) there is placed on the opposite layer a second path (622) to be shielded, and the shielding arrangement placed on the lower layer is a second line of SMD elements (625) placed over the second path (622) to be shielded.

9. The board according to claim 6, **characterized in that** the board has at least three layers and that the shielding arrangement (722) placed on the lower layer is placed on the inner layer and is common to the arrangement of elements constituting the shield on the first (711) and on the second (741) outer layer.

10. The board according to claim 1, **characterized in that** the SMD elements are resistors with resistance close to zero.

11. A method for manufacturing a printed circuit board with a shielded path (212) placed on an outer layer (211) of the printed circuit board comprising the steps of:
placing shielding paths or planes (213, 214) at both sides along the shielded path (212),
connecting the shielding paths or planes (213, 214) to the ground,
placing a line of SMD elements (215) with contacts over the shielded path (212),
connecting the contacts (216, 217) extending beyond the shielded path (212) to the shielding paths or planes (213, 214).
